# EUROPÄISCHE PATENTSCHRIFT

(11) **EP 0 413 098 B1**
(45) Veröffentlichungstag und Bekanntmachung des Hinweises auf die Patenterteilung: **10.08.1994**
(21) Anmeldenummer: 90110746.6
(22) Anmeldetag: 07.06.1990
(51) Int. Cl.: B65G 37/02, H05K 13/00

(54) **Verfahren zum Behandeln von stückförmigen Teilen in Durchlaufanlagen, sowie Vorrichtung zur Durchfürung dieses Verfahrens**
Method for the treatment of pieces in a pass-through plant and device for carrying out this method
Procédé pour le traitement d'articles dans une installation en continu et dispositif pour la mise en oeuvre de ce procédé

(30) Priorität: 16.06.1989 DE 3919735
(43) Veröffentlichungstag der Anmeldung: 20.02.1991
(73) Patentinhaber: ATOTECH Deutschland GmbH, 10553 Berlin (DE)
(72) Erfinder: Kosikowski, Thomas, D-8501 Burgthann (DE)
(74) Vertreter: Effert, Udo, Dipl.-Ing.

(56) Entgegenhaltungen:
- DE-A- 2 644 136
- DE-B- 1 262 327
- FR-A- 2 306 788

## Beschreibung

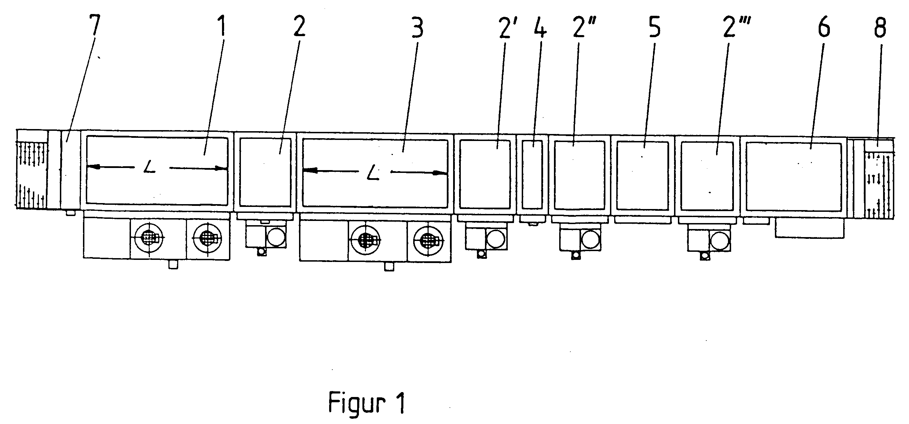

Die Erfindung betrifft zunächst ein Verfahren zum Behandeln von stückförmigen Gut gemäß dem Oberbegriff des Ansprüches 1. Bei dem stückförmigen Gut kann es sich dabei beispielsweise um Leiterplatten handeln, die in horizontaler Lage durch eine Anlage transportiert werden, wobei eine naßchemische Behandlung erfolgt, die in mehreren Schritten durchgeführt wird. Derartige Durchlaufanlagen sind bekannt. So besteht zum Beispiel eine Anlage für die Reinigung der Bohrlöcher in Leiterplatten aus den Verfahrensschritten Quellen, Spülen, Ätzen, Spülen, Spülen, Entgiften, Spülen, Trocknen. Dieser Stand der Technik ist in Fig. 1 dargestellt und wie hieraus ersichtlich, benötigen die Schritte "Quellen" und "Ätzen" eine längere Behandlungsstrecke als die anderen Schritte. Die Längen der jeweiligen Schritte sind in der Fig. 1 im richtigen Verhältnis dargestellt. Das bedeutet, daß für eine genügend lange Einwirkdauer der Behandlungslösungen für "Quellen" und "Ätzen", die Module der entsprechenden Behandlungsstationen länger ausgebildet werden müssen. Solange sich die Unterschiede dabei in Bereichen bewegen, wie in Fig. 1 dargestellt, gibt es auch keine Schwierigkeiten, eine solche Linie von hintereinander angeordneten Behandlungsstationen räumlich unterzubringen.

Sind aber in einer solchen Behandlungslinie Stationen notwendig, bei denen gewisse Behandlungsschritte eine wesentlich längere Zeit benötigen (wie es z.B. bei der chemischen Metallisierung der Fall ist), so ergeben sich beim herkömmlichen Verfahren, alles in einer Linie anzuordnen, durch die das Behandlungsgut mit konstanter Geschwindigkeit transportiert wird, unzumutbar große Anlagenlängen. Um diesem Mangel abzuhelfen hat man bereits (siehe DE-OS 35 29 313) vorgesehen, Module für Behandlungsvorgänge mit großem Zeitbedarf so auszubilden, daß das Behandlungsgut am Moduleinlauf von der horizontalen in die vertikale Lage geschwenkt, von Warenträgern aufgenommen und in die Behandlungslösung eingesenkt wird. Eine Vielzahl von Warenträgern befinden sich gleichzeitig im Behandlungsablauf. Sie werden taktend zum Ende des Moduls hin verschoben und dort wieder ausgehoben. Hierauf wird das Behandlungsgut vom Warenträger getrennt. Nachdem es wieder in die horizontale Lage abgeschwenkt ist, wird es in nachfolgenden Behandlungsstationen in der üblichen Weise in horizontaler Lage weiterbehandelt. Eine solche Vorrichtung verringert den Platzbedarf einer derartigen Behandlungslinie ganz wesentlich. Ihr Nachteil ist jedoch, daß ein derartiges Modul sehr aufwendig und damit teuer ist.

Die Erfindung hat deshalb zunächst die Aufgabe, ein Verfahren gemäß dem Oberbegriff des Ansprüches 1 so auszugestalten daß die kontinulierliche Behandlung von stückförmigen Gut in einfachen und platzsparenden Durchlaufanlagen, die auch Behandlungsvorgänge oder Abschnitte mit großem Zeitbedarf aufweisen, möglich ist.

Die Lösung dieser Aufgabe wird, ausgehend vom Oberbegriff des Ansprüches 1, in den Merkmalen des Kennzeichens des Ansprüches 1 gesehen. Durch die Aufteilung der Behandlungsschritte mit zeit intensiven Behandlungsvorgängen auf n parallele Bahnen verringert sich die Länge dieses Abschnittes der Anlage etwa auf ein n-tel der Länge, die für eine einzige, die Behandlung sämtlicher Teile durchführenden Bahn benötigt werden würde. Die Transportgeschwindigkeit der Teile in den einander parallelen Bahnen beträgt dabei nur den n-ten Teil der Transportgeschwindigkeit der Teile durch die gesamte Anlage. Hiermit werden Lücken oder Staus beim Transport der Teile durch die gesamte Anlage vermieden, d.h. ein konstanter Durchsatz der Teile durch die gesamte Anlage erreicht. Es versteht sich, daß in den einander parallelen Bahnen eines Behandlungsschrittes die Geschwindigkeit v′ jeweils dieselbe ist.

Der Erfindung liegt ferner die Aufgabe zugrunde, eine Vorrichtung zur Durchführung des vorstehend erläuterten Verfahrens zu schaffen.

Die Lösung der zuletzt genannten Aufgabe wird in den Merkmalen des Anspruches 2 gesehen. Dieser Anspruch besteht aus den prinzipiellen Merkmalsgruppen, nämlich den einzelnen Bahnen, den Mitteln zur Zufuhr (bzw. Abfuhr) der Teile auf die (bzw. von den) einzelnen Bahnen und schließlich der Schaffung eines Antriebes mit der erforderlichen Geschwindigkeit. Eine Ausführungsform der erfindungsgemäßen Vorrichtung ist Inhalt des Ansprüches 5. Diese Aufteilung auf mehrere nebeneinander liegende Spuren bedeutet zwar einen größeren Platzbedarf in der Breite, doch ist das Kriterium für die Unterbringung einer solchen Durchlaufanlage in der Regel nicht die Breite, sondern die Länge der Anlage. Ferner gehören zu einer derartigen Anlage üblicherweise verschiedene Nebengeräte wie Vorratsbehälter, Filter, Pumpen etc., die ohnehin neben der Durchlaufanlage aufgestellt werden, allerdings bei Vorhandensein der erfindungsmäßigen Lösung nicht im Bereich der parallelen Bahnen.

Bei der Ausführungsform gemäß Anspruch 7 sind die einander parallelen Behandlungsbahnen übereinander angeordnet. Dies hat die geringsten Auswirkungen auf den Platzbedarf der gesamten Anlage. Da die Durchlaufebene für das Behandlungsgut so gewählt werden kann, daß für das Aufgeben des Gutes am Anfang der Anlage und für das Abnehmen am Ende eine bedienungsfreundliche Höhe gegeben ist, ist unterhalb dieser Ebene Platz vorhanden für zusätzliche Bahnen.

Während bei der Ausführungsform nach Anspruch 8 die Transportrichtung für das Behandlungsgut in allen Bahnen gleich ist, wechselt bei der Ausführungsform nach Anspruch 9 die Transportrichtung. Bei dieser Form ist die Anzahl der Bahnen immer ungerade, also 3, 5, usw.

Die nebeneinander angeordneten Bahnen können aus Behandlungsmodulen bestehen, wie sie vom grundsätzlichen Aufbau her auch in den "einbahnigen" Bereichen der Anlage verwendet werden. Sie können völlig voneinander unabhängige Module sein. Ihr Transportsystem für die Teile, z.B. Leiterplatten, kann einen eigenen Antrieb haben, es kann aber auch mit einem übersetzungsverhältnis, das ihrem Geschwindigkeitsverhältnis gegenüber den einbahnigen Bereichen entspricht, an deren Antrieb angekuppelt sein. In diesem Fall sind auf einfache Weise synchrone Durchsatzverhältnisse zwischen ein- und mehrbahnigen Bereichen erzielbar.

Anstelle von üblich aufgebauten Modulen kann auch eine spezielle Ausführung, bestehend aus zwei oder mehr Behandlungsbahnen in einem gemeinsamen Gehäuse eingesetzt werden. Diese Ausführung wird bei übereinander angeordneten Bahnen gewählt.

Weitere bevorzugte Ausführungsformen der Erfindung sind den weiteren Unteransprüchen, zu entnehmen.

In der Zeichnung zeigt:
- Fig. 1:: eine Anlage gemäß dem Stand der Technik,
- Fig. 2:: in der Draufsicht schematisch einen Teil einer Anlage mit einer zweibahnigen Behandlungsstation die sich zwischen zwei einbahnigen Behandlungsabschnitten befindet,
- Fig. 3:: in der Seitenansicht und schematisch ein weiteres Ausführungsbeispiel der Erfindung,
- Fig. 4:: in der Seitenansicht und schematisch ein anderes Ausführungsbeispiel der Erfindung.

Fig. 1 zeigt die Draufsicht auf eine Anlage für die chemische Behandlung von Leiterplatten im horizontalen Durchlauf. Die in dieser Anlage gebildete Linie von Behandlungsstationen besteht lt. diesem Ausführungsbeispiel aus den Behandlungsstationen: Quellen 1, Spülen 2, Kaliumpermanganatätzen 3, Spülen 2′, Antriebsstation 4, Spülen 2˝, Entgiften 5, Spülen 2‴ und Trocknen 6. Zum Eingeben der Leiterplatten in die Anlage dient die Einlaufstation 7, während die Abnahme der fertig behandelten Platten an der Auslaufstation 8 erfolgt. Die gesamte Länge der Linie beträgt bei diesem Beispiel ca. 8 m bei einer Durchlaufgeschwindigkeit der Leiterplatten von ca. 1 m/min. Eine Linie dieser Art ist also leicht räumlich unterzubringen. Die Behandlungszeiten in den Stationen sind hier nicht länger als 1,5 Minuten, woraus sich die in der Fig. 1 dargestellten maßstäblichen Größenverhältnisse ergeben. Unterhalb der eigentlichen Behandlungsstationen sind Zusatzgeräte wie Pumpen und Filter dargestellt.

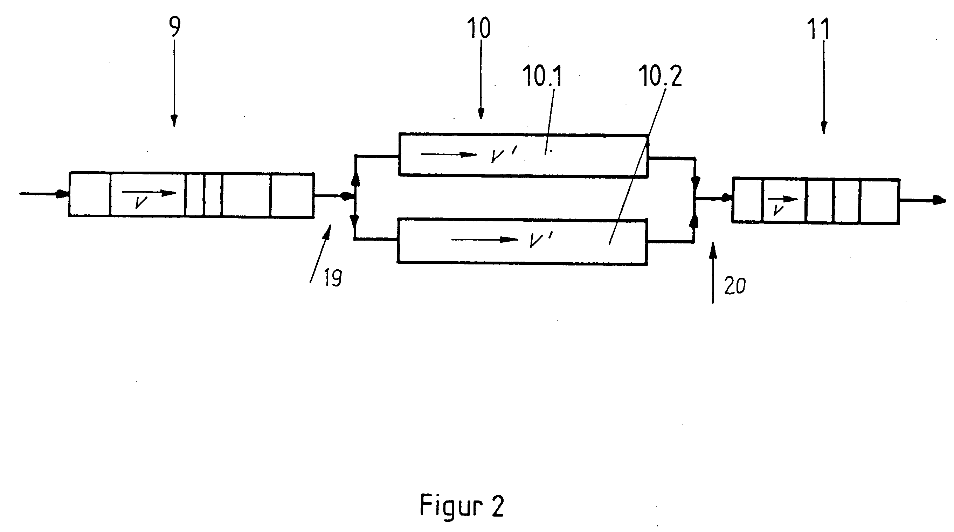

Wenn aber die Länge L einer oder mehrerer Behandlungsstationen eine größere Behandlungszeit und damit einen größeren Raumbedarf in der Längsrichtung einer solchen Linie benötigt, so kann dann dieses Problem mit der Erfindung behoben werden. Hierzu zeigt Fig. 2 schematisch das erfindungsgemäße Verfahren der Aufteilung des Behandlungsschrittes 10 der Behandlungslinie 9, 10, 11 auf zwei bzw. mehr parallele Bahnen 10.1 und 10.2 dieses Behandlungsschrittes 10, bei dem eine größere Zeitdauer für den entsprechenden Behandlungsvorgang erforderlich ist. Bei einem solchen Behandlungsschritt kann es sich beispielsweise um die chemische Metallisierung der Bohrlochwandungen von Leiterplatten handeln. Die vorgenannte Behandlungslinie ist dabei so aufgebaut, daß die Vorbehandlung in dem einbahnigen Abschnitt 9 erfolgt und der Vorgang der chemischen Metallisierung in dem zweibahnigen Abschnitt 10 mit den beiden parallelen Bahnen 10.1 und 10.2, während die Nachbehandlung in dem einbahnigen Abschnitt 11 vorgenommen wird.

Die Transportgeschwindigkeit v′ in den Bahnen 10.1 und 10.2 des Abschnittes 10 beträgt bei der dargestellten zweibahnigen Ausführung nur die Hälfte der Transportgeschwindigkeit v in den einbahnigen Abschnitten 9 und 11. Die Länge des Abschnittes 10 kann in der erfindungsgemäß vorgesehenen zweibahnigen Ausführung etwa auf die Hälfte der Länge reduzuiert werden, die er bei einbahniger Ausgestaltung für die entsprechende Behandlung der Teile benötigen würde, da gemäß der Erfindung die notwendige Behandlungszeit auf die beiden Bahnen 10.1 und 10.2 verteilt ist.

Die vom Abschnitt 9 herkommenden, zu behandelnden Teile werden an der Stelle 19 so auf die Bahnen 10.1 und 10.2 verteilt, daß jede Bahn die gleiche Menge an zu behandelnden Teilen erhält. Hierzu können sogenannte "Weichen", Transportbänder und dergleichen mehr dienen, wie sie zur Umleitung eines zu fördernden Gutes in andere Richtungen bekannt sind. Sinngemäß gleiche Mittel sind beim übergang von den beiden Bahnen 10.1 und 10.2 auf den Abschnitt 11 vorgesehen, um die von diesen beiden Bahnen her ankommenden Teile nacheinander dem Abschnitt 11 zuzuführen. Generell empfiehlt sich, von den ankommenden Teilen bei 19 eines zur einen Bahn und das nächste zur anderen Bahn zu leiten u.s.w., bzw. bei 20 alternierend ein Teil der einen Bahn und ein Teil der anderen Bahn dem Abschnitt 11 zuzuführen. Insgesamt erhält man einen konstanten Durchsatz der gesamten Linie 9-10-11 mit den zu behandelnden Teilen.

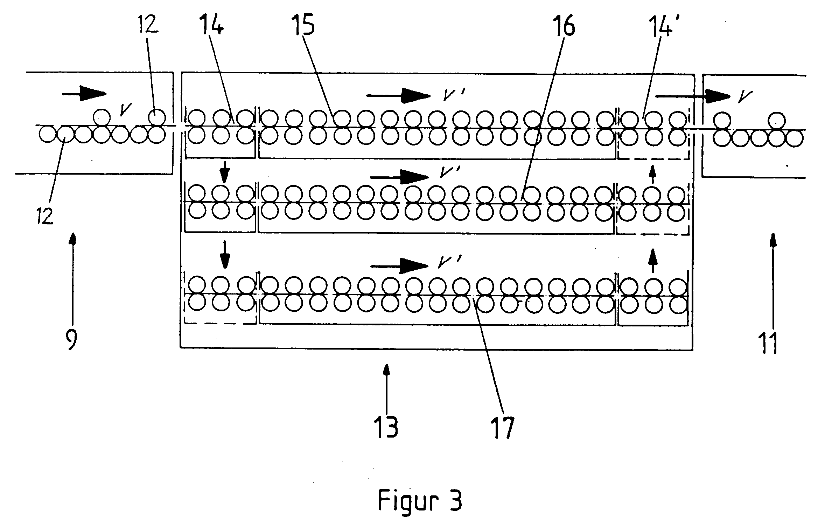

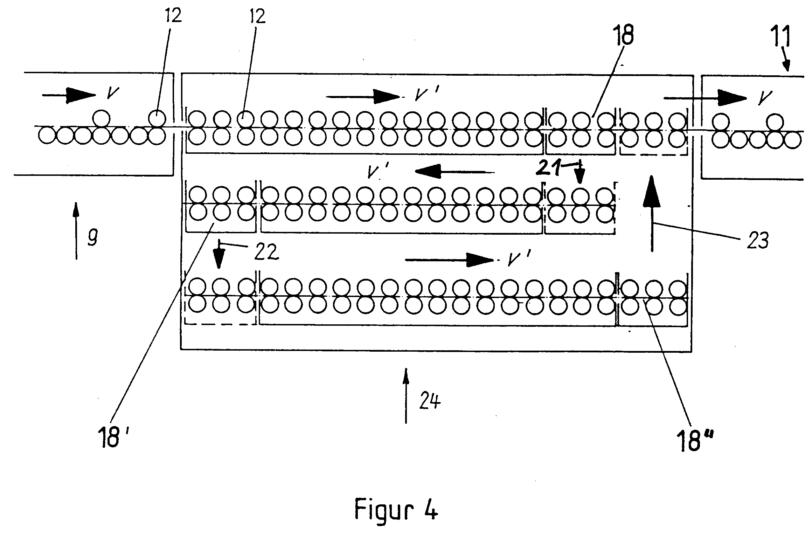

Während im Beispiel der Fig. 2 die beiden Bahnen 10.1 und 10.2 nebeneinander liegen, sind in den Beispielen der Fig. 3 und 4 die jeweiligen Bahnen 15, 16, 17 bzw. 18, 18′, 18˝ übereinander angeordnet. Dabei haben im Beispiel der Figuren 3 die Bahnen 15, 16, 17 jeweils die gleiche, mit Pfeilen angegebene Transportrichtung, wobei von den bereits vorstehend erwähnten einbahnigen Abschnitten 9 und 11 jeweils ,nur der an den hier mit 13 bezifferten dreibahnigen Abschnitt angrenzende Teil dargestellt ist. Aus dem bereits früher gesagten ergibt sich, daß die Geschwindigkeit v′ der Bahnen 15, 16 und 17 des transportierten Gutes gleich v/3 ist. Somit wird in dem zeitintensiven Abschnitt 13 die bei einbahniger Ausgestaltung dieses Abschnittes notwendige Länge auf etwa ein Drittel reduziert. Das zu behandelnde Gut, z.B. die erwähnten Leiterplatten, ist in den Zeichnungen nicht dargestellt. Solche Leiterplatten werden von den Transportwalzen 12 erfaßt, wobei die Transportwalzen 12 von beiden Seiten an den Leiterplatten anliegen, die zwischen diesen Transportwalzen in der angegebenen Richtung bewegt werden.

Im Beispiel der Fig. 3 werden die aus dem Abschnitt 9 ankommenden Teile durch eine Hubeinrichtung 14 zur jeweiligen Bahn 15, 16 oder 17 gebracht, dort in der angegebenen Richtung weitertransportiert und zugleich dabei behandelt, bis dann durch die weitere Hubeinrichtung 14′ die Teile in die Ebene des Abschnittes 11 gebracht und diesem Abschnitt zugeführt werden.

Anstelle der in Fig. 3 dargestellten drei Bahnen könnten auch nur zwei Bahnen übereinander und gegebenenfalls auch mehr als drei Bahnen übereinander vorgesehen sein. Die beiden letztgenannten Varianten sind zeichnerisch nicht dargestellt.

In Fällen, in denen das Absenken der zu behandelnden Teile über mehrere Bahnen nach unten, bzw. das Anheben nach oben mit den Hubeinrichtungen 14, 14′ der Fig. 3 im Hinblick auf die hierfür nur geringe zur Verfügung stehende Zeit nicht möglich ist (wenn also z.B. Leiterplatten mit in Transportrichtung kleinen Abmessungen behandelt werden sollen), kann auch gemäß Fig. 4 vorgegangen werden. Die zu behandelnden Teile werden vom Abschnitt 9 der oberen Bahn 18 eines Abschnittes 24 zugeführt, von dieser mittels einer Hubeinrichtung 21 in die Ebene der nächsten Bahn 18 abgesenkt, in der die Teile dann in der entgegengesetzten Richtung zurücktransportiert werden. Nach Durchlaufen dieser Bahn und Absenken mit Hilfe einer Hubeinrichtung 22 auf die Ebene der Bahn 18˝ werden die Teile wieder in der Transportrichtung der Bahn 18 bewegt, um mittels einer weiteren Hubeinrichtung 23 nach oben auf die Ebene des Abschnittes 11 gebracht und diesen zugeführt zu werden. Auch hier gelten hinsichtlich der Geschwindigkeiten v′ und v, sowie zur Längenverkürzung die Ausführungen zu dem ebenfalls dreibahnigen Ausführungsbeispiel der Fig. 3. Die Variante gemäß Fig. 4 könnte auch bei einer anderen ungeraden Zahl von Bahnen, z.B. mit fünf Bahnen verwirklicht werden.

Die Antriebe der dargestellten Abschnitte oder Bereiche sind zeichnerisch nicht dargestellt. So kann z.B. eine über die gesamte Länge einer solchen Linie oder Anlage sich erstreckende Antriebswelle vorgesehen sein, die von einem Motor getrieben wird. Von dieser durchgehenden Welle werden dann für die einzelnen Abschnitte die Abtriebe für die Geschwindigkeiten v und v′ abgeleitet. Dabei muß der Abtrieb zu den mehrbahnigen Abschnitten entsprechend der angegebenen Übersetzung reduziert werden, d.h. im Beispiel der Fig. 2 auf die Hälfte und im Beispiel der Fig. 3 und 4 auf ein Drittel, und zwar in dem Sinne, daß die Transportgesohwindigkeiten v, v′ sich entsprechend verhalten. Die Abtriebe können Kegeltriebe sein.

## Patentansprüche

1. Verfahren zum Behandeln von stückförmigen Teilen, insbesondere gelochten Leiterplatten in Durchlaufanlagsn mit mehreren Behandlungsschritten, wobei die Teile die Anlage mit einer Transportgeschwindigkeit (v) durchlaufen und wobei zumindest ein Behandlungsschritt mehr Zeit erfordert als die übrigen Behandlungsschritte, dadurch gekennzeichnet, daß Behandlungsschritte, die eine längere Behandlungszeit erfordern, in eine Anzahl n paralleler Bahnen (10.1, 10.2; 15, 16, 17; 18, 18′, 18′′) aufgeteilt werden, wobei n ≧ 2 ist, und daß die Transportgeschwindigkeit (v′) der zu behandelnden Teile durch die einander parallelen Bahnen dieses Behandlungs schrittes gleich v/n gewählt wird.

2. Vorrichtung in Form einer Durchlaufanlags aus mehreren in einer Linie hintereinander angeordneter Behandlungsstationen oder Abschnitten(im folgenden kurz "Abschnitte" genannt) zum Durchführen des Verfahrens nach Anspruch 1 , dadurch gekennzeichnet, daß derjenige Abschnitt bzw. diejenigen Abschnitte (10, 13, 24), die eine größere Behandlungszeit als die übrigen Abschnitte (9, 11) erfordern aus mehreren, parallel zueinander verlaufenden und in der Behandlung einander gleichen Bahnen (10.1, 10.2; 15, 16, 17; 18, 18′, 18˝) bestehen, daß Mittel bzw. Vorrichtungen zur Zufuhr der Teile auf die einzelnen Bahnen eines mehrbahnigen Abschnittes und zur Behandlung innerhalb dieser einzelnen Bahnen, sowie zur Abnahme von diesen Bahnen und Abtransport in einen weiteren Abschnitt vorgesehen sind und daß ein Antrieb für den Transport der Teile auf den einander parallelen Bahnen eines solchen Abschnittes mit einer Geschwindigkeit (v′) vorgesehen ist, die in der Relation v′ = v/n zur Geschwindigkeit (v) der Teile durch die gesamte Anlage, bzw. Linie steht.

3. Vorrichtung nach Anspruch 2 mit einer gemeinsamen Antriebswelle, die entlang der Linie von Abschnitten oder Behandlungsstationen verläuft, wobei hiervon Abtriebe zu den einzelnen Abschnitten führen, dadurch gekennzeichnet, daß die Abtriebe zu den einander parallelen Bahnen (10.1, 10.2; 15, 16, 17; 18, 18′, 18˝) der betreffenden Abschnitte (10, 13, 24) entsprechend dem in Anspruch 1 genannten Verhältnis gegenüber den Abtrieben zu den einbahnigen Abschnitten untersetzt sind.

4. Vorrichtung nach Anspruch 3, gekennzeichent durch Abtriebe mittels Kegelräder.

5. Vorrichtung nach einem der Ansprüche 2 bis 4, dadurch gekennzeichnet, daß die einander parallelen Bahnen (10.1, 10.2) eines Abschnittes (10) nebeneinander angeordnet sind.

6. Vorrichtung nach Anspruch 5, dadurch gekennzeichnet) daß am Eingang und Ausgang der nebeneinander angeordneten Bahnen Mittel zur alternierenden Zuleitung eines Teiles zu einer Bahn und zur anderen Bahn, bzw. zur entsprechenden alternierenden Abnahme der Teile von der Bahn vorgesehen sind.

7. Vorrichtung nach einem der Ansprüche 2 bis 4, dadurch gekennzeichnet, daß einander parallele Bahnen (15, 16, 17; 18, 18′, 18˝) entsprechende Abschnitte (13, 24) übereinander angeordnet sind.

8. Vorrichtung nach Anspruch 7, dadurch gekennzeichnet, daß die Teile in den Bahnen die gleiche Transportrichtung aufweisen (Fig. 3).

9. Vorrichtung nach Anspruch 7, dadurch gekennzeichnet) daß die übereinander angeordneten Bahnen entgegengesetzte Transportrichtungen für die Teile aufweisen (Fig. 4).

10. Vorrichtung nach einem der Ansprüche 7 bis 9, gekennzeichnet durch Hub- oder Absenkmittel (14, 14′; 21, 22, 23), um die zu behandelnden Teile aus der Ebene der einen Bahn zur Ebene der anderen Bahn zu bringen.

## Claims

1. Method of treating articles, more especially perforated printed circuit boards in transit systems, with a plurality of treatment steps, the articles passing through the system at a speed of conveyance (v), and at least one treatment step requiring more time than the other treatment steps, characterised in that treatment steps which require a longer treatment period are divided into a number n of parallel paths (10.1, 10.2; 15, 16, 17; 18, 18', 18''), n being greater than or equal to 2, and in that the speed of conveyance (v') of the articles to be treated through the paths of this treatment step, which paths lie parallel to one another, is selected to be equal to v/n.

2. Apparatus in the form of a transit system formed from a plurality of treatment stations or sections (hereinafter called "sections" for short), which are disposed behind one another in a line, for accomplishing the method according to claim 1, characterised in that the section or sections (10, 13, 24) requiring a greater treatment period than the other sections (9, 11) comprise a plurality of paths (10.1, 10.2; 15, 16, 17; 18, 18', 18''), which extend parallel to one another and are identical to one another in respect of the treatment, in that means or devices are provided for supplying the articles to the individual paths of a multiply-pathed section and for treating such within these individual paths, as well as for removing the articles from these paths and conveying such away into a further section, and in that a drive means is provided for conveying the articles along the paths of such a section, which paths lie parallel to one another, at a speed (v') which is in the relationship of v' = v/n relative to the speed (v) of the articles through the entire system or line.

3. Apparatus according to claim 2, having a common drive shaft which extends along the line of sections or treatment stations, driven ends thereof leading to the individual sections, characterised in that the driven ends leading to the paths (10.1, 10.2; 15, 16, 17; 18, 18', 18'') of the pertinent sections (10, 13, 24), which paths lie parallel to one another, are reduced according to the ratio mentioned in claim 1 compared with the driven ends leading to the single-path sections.

4. Apparatus according to claim 3, characterised by ends driven by means of bevel gears.

5. Apparatus according to one of claims 2 to 4, characterised in that the paths (10.1, 10.2) of a section (10), which lie parallel to one another, are disposed adjacent one another.

6. Apparatus according to claim 5, characterised in that means for alternately conducting an article to one path and to the other path, or respectively for the corresponding alternate removal of the articles from the path, are provided at the inlet and outlet of the paths disposed adjacent one another.

7. Apparatus according to one of claims 2 to 4, characterised in that paths (15, 16, 17; 18, 18', 18'') of appropriate sections (13, 24), which paths lie parallel to one another, are disposed above one another.

8. Apparatus according to claim 7, characterised in that the articles in the paths have the same direction of conveyance (Fig. 3).

9. Apparatus according to claim 7, characterised in that the paths which are disposed above one another have oppositely orientated directions of conveyance for the articles (Fig. 4).

10. Apparatus according to one of claims 7 to 9, characterized by raising or lowering means (14, 14'; 21, 22, 23) in order to bring the articles to be treated from the plane of one path to the plane of the other path.

## Revendications

1. Procédé pour le traitement de pièces unitaires, en particulier de cartes imprimées perforées dans des installations à passage continu, comportant plusieurs étapes de traitement, les composants traversant l'installation à une vitesse de transport (v) et au moins une étape de traitement nécessitant plus de temps sur les autres étapes de traitement, caractérisé en ce que les étapes de traitement, qui nécessitent un temps de traitement plus long sont divisées en un nombre de n voies (10.1,10.2, 15, 16, 17, 18, 18', 18'') parallèles, n étant ≧ 2, et en ce que la vitesse de transport (v') des pièces à traiter sur les voies parallèles l'une à l'autre, de cette étape de procédé, est choisie pour être égale à n/v.

2. Dispositif de la forme d'une installation à passage continu, constitué de plusieurs stations ou tronçons de traitement (ci-après dénommés tronçons) disposés en ligne les uns derrière les autres, destinés à mettre en oeuvre le procédé selon la revendication 1, caractérisé en ce que le ou les tronçons considérés (10, 23, 24), qui nécessitent un temps de traitement plus long que les autres tronçons (9, 11), sont constitués de plusieurs voies (10.1, 10.2, 15, 16, 17, 18, 18', 18'') s'étendant parallèlement les unes aux autres, semblables en ce qui concerne le traitement, en ce que des moyens ou des dispositifs sont prévus, destinés à amener les pièces sur les diverses voies d'un tronçon à plusieurs voies, à procéder au traitement à l'intérieur de ces diverses voies, ainsi qu'à prélever les pièces de ces voies et à les transporter vers un autre tronçon, et en ce qu'un mécanisme est prévu, destiné au transport des pièces sur les voies parallèles les unes aux autres d'un tronçon de ce type, à une vitesse (v'), qui forme un rapport v' = v/n par rapport à la vitesse (v) des pièces sur l'ensemble de l'installation ou de la ligne.

3. Dispositif selon la revendication 2, comportant un arbre d'entraînement commun qui s'étend le long de la ligne de tronçons ou de stations de traitement, des arbres de sortie menant, à partir dudit arbre d'entraînement, vers les différents tronçons, caractérisé en ce que les arbres de sortie menant aux voies parallèles (10.1, 10.2, 15, 16, 17, 18, 18', 18'') des tronçons concernés (10, 13, 24), sont démultipliés selon le rapport mentionné à la revendication 1, par rapport aux arbres de sorties menant aux tronçons à une seule voie.

4. Dispositif selon la revendication 3, caractérisé par les arbres de sortie pourvus de pignons coniques.

5. Dispositif selon l'une quelconque des revendications 2 à 4, caractérisé en ce que les voies (10.1, 10.2) parallèles les unes aux autres d'un tronçon (10) sont disposées les unes à côté des autres.

6. Dispositif selon la revendication 5, caractérisé en ce que des moyens sont prévus pour amener en alternance une pièce vers une voie et vers une autre voie, ou prélever en alternance de manière correspondante les pièces de la voie étant prévues à l'entrée et à la sortie des voies disposées les unes à côtés des autres.

7. Dispositif selon l'une quelconque des revendications 2 à 4, caractérisé en ce que des tronçons (13, 24) correspondant aux voies (15, 16, 17, 18, 18', 18'') parallèles les unes aux autres sont disposés les uns au-dessus des autres.

8. Dispositif selon la revendication 7, caractérisé en ce que les pièces se déplacent sur les voies selon la même direction de transport (figure 3).

9. Dispositif selon la revendication 7, caractérisé en ce que les voies placées les unes au-dessus des autres présentent des directions opposées de transport des pièces (figure 4).

10. Dispositif selon l'une quelconque des revendications 7 à 9, caractérisé par des moyens d'élévation ou d'abaissement (14, 14', 21, 22, 23), destinés à transférer les pièces à traiter, du plan d'une voie vers le plan d'une autre voie.
